# EUROPEAN PATENT APPLICATION

(11) **EP 4 752 938 A1**
(43) Date of publication of application: **03.06.2026**
(21) Application number: 24844613.0
(22) Date of filing: 10.07.2024
(51) Int. Cl.: H01L 23/64, H01L 23/522, H01L 21/768

(54) **SILICON CAPACITOR AND PREPARATION METHOD THEREFOR, AND CHIP AND PREPARATION METHOD THEREFOR**

(30) Priority: 24.07.2023 CN 202310914678
(71) Applicant: Spreadtrum Communications (Shanghai) Co., Ltd., Shanghai 201203 (CN)
(72) Inventor: YAO, Ll, Shanghai 201203 (CN); LIU, Mengqi, Shanghai 201203 (CN); LIU, Zhinong, Shanghai 201203 (CN); QIU, Yuanhong, Shanghai 201203 (CN)
(74) Representative: Ipsilon
(86) International application number: PCT/CN2024/104605
(87) International publication number: WO 2025/020919

(57) **Abstract**

The present application provides a silicon capacitor and a preparation method therefor, and a chip and a preparation method therefor. The silicon capacitor comprises a silicon substrate and two solder points arranged at an interval on one side of the silicon substrate. The center distance between the two solder points is a preset distance, and the preset distance is made equal to the center distance between two adjacent solder pads in a packaging substrate. According to the present application, the center distance between the two solder points is made equal to the center distance between two solder pads, so that the silicon capacitor can be conveniently soldered to a packaging substrate and the wiring design in the packaging substrate would not be affected, thus guaranteeing a shortest power supply path without increasing the packaging area. The increase in the overall size of a chip due to the increase in the wiring length of a packaging substrate caused by the unequalness between the center distance between two solder pads in the packaging substrate and the two solder points in the silicon capacitor is avoided. in addition, the decoupling effect and the signal performance can further be improved.

## Description

This application claims priority to Chinese Patent Application No. 202310914678.X, entitled "SILICON CAPACITOR AND PREPARATION METHOD THEREFOR, AND CHIP AND THEREFOR", and filed with the China National Intellectual Property Administration on July 24, 2023, the entirety of which is incorporated herein by reference.

### TECHNICAL FIELD

This application relates to the field of capacitor technology, and particularly to silicon capacitor and preparation method therefor, and chip and therefor.

### BACKGROUND

At present, capacitors are usually surface-mounted on a top side or a bottom side of a package substrate so as to reduce the IR drop across the capacitors. However, as a pin density on the package substrate continues to increase, due to the mismatch between a pitch of solder joints of a capacitor and a pitch of solder balls on the package substrate, redistribution and interconnection between the package substrate and solder pads is required in the traditional method of surface-mounting a standard capacitor. This increases solder pads and routing for capacitors, which occupy a significant amount of layout area, resulting in increased chip area and substantial degradation in electrical performance.

### SUMMARY

In view of this, a first aspect of this application provides a silicon capacitor. The silicon capacitor comprises a silicon body, and two solder joints disposed on one side of the silicon body and spaced apart, wherein a center-to-center pitch between the two solder joints is a preset distance which is equal to a center-to-center pitch between two adjacent solder pads on a package substrate.

The two solder joints of the silicon capacitor provided in the first aspect of this application are used to be soldered to the two adjacent solder pads on the package substrate, thereby achieving electrical connection between the silicon capacitor and the package substrate. In this application, the center-to-center pitch between the two solder joints is adjusted to be equal to the center-to-center pitch between two solder pads. This may not only facilitate soldering of the silicon capacitor to the package substrate, but also does not affect the routing design in the package substrate, ensuring the shortest path of power supply, without increasing the package area. Further, this prevents increasing the routing length of the package substrate and thus increasing an overall size of a chip due to the fact that the center-to-center pitch between two solder pads on the package substrate is unequal to the center-to-center pitch between two solder joints of the silicon capacitor. Also, decoupling effect and signal performance are improved.

Wherein, the preset distance is 0.35mm or 0.4mm.

Wherein, any one of the two solder joints is set to be closer to another of the two solder joints so that the center-to-center pitch between the two solder joints is the preset distance; or each of the two solder joints is set to be closer to another of the two solder joints so that the center-to-center pitch between the two solder joints is the preset distance.

Wherein, the silicon body comprises a silicon body layer and a redistribution layer formed on one side of the silicon body layer, wherein two connection portions are disposed on one side of the redistribution layer opposite the silicon body layer, and each of the solder joints is disposed on one of the connection portions, and the center-to-center pitch between the two connection portions is the preset distance.

A second aspect of this application provides a manufacturing method for a silicon capacitor. The manufacturing method comprises:
providing a wafer;
performing sputtering, electroplating, and solder ball placement on the wafer sequentially to obtain a wafer with an array of silicon capacitors;
performing a half cutting process on a surface of one side of the wafer with the array of the silicon capacitors;
grinding a surface of another side of the wafer with the array of the silicon capacitors to obtain multiple silicon capacitors which are separated from each other; wherein each of the silicon capacitors comprises a silicon body and two solder joints disposed on one side of the silicon body and spaced apart, wherein a center-to-center pitch between the two solder joints is a preset distance which is equal to a center-to-center pitch between two adjacent solder pads on a package substrate.

A third aspect of this application provides a wafer dicing method for silicon capacitors, which solves problems of dicing outlines of ultra-thin silicon capacitors by cutting to half the depth of dicing streets between the silicon capacitors of chips firstly, and then separating the individual silicon capacitors through grinding, thereby reducing the difficulty of manufacturing silicon capacitors. The silicon capacitor provided in the above embodiments of this application may be manufactured through the above manufacturing process, which enables the center-to-center pitch between two solder joints to be equal to the center-to-center pitch between two solder pads when the silicon capacitor is soldered to the package substrate. This may not only facilitate soldering of the silicon capacitor to the package substrate, but also does not affect the routing design in the package substrate, thereby ensuring the shortest path of power supply, without increasing the package area. Further, this prevents increasing the routing length of the package substrate and thus increasing an overall size of the chip due to the fact that the center-to-center pitch between two solder pads on the package substrate is unequal to the center-to-center pitch between two solder joints of the silicon capacitor. Also, decoupling effect and signal performance are improved.

A fourth aspect of this application provides a chip. The chip comprises a package substrate and the silicon capacitor provided in the first aspect of this application, wherein the package substrate comprises a substrate, multiple solder pads disposed on one side of the substrate and spaced apart, and multiple solder balls disposed on the one side of the substrate and spaced apart, wherein a center-to-center pitch between two adjacent solder pads is equal to a center-to-center pitch between two adjacent solder balls, and equal to a preset distance between two solder joints of the silicon capacitor, and wherein the solder joints are soldered to the solder pads.

**In** the chip provided in the fourth aspect of this application, the silicon capacitor provided in the first aspect of this application could be adopted to improve decoupling effect and signal performance without increasing an overall size of the chip.

Wherein, each of the solder joints includes a base disposed on a silicon body of the silicon capacitor, and a soldering portion disposed on a side of the base opposite the silicon body, wherein an orthographic projection of the soldering portion onto the substrate is located within a solder pad.

Wherein, a center of the orthographic projection of the soldering portion onto the substrate overlaps with a center of the solder pad.

Wherein, in a direction perpendicular to an arrangement direction of the two solder joints, a width of the silicon body is smaller than a width of the solder pad; or the width of the silicon body is greater than or equal to the width of the solder pad.

A fifth aspect of this application provides a manufacturing method for a chip. The manufacturing method comprises:
providing a package substrate and attaching a die onto one side of the package substrate;
performing molding process on the one side of the package substrate;
providing the silicon capacitor as in the first aspect of this application, and soldering the silicon capacitor to another side of the package substrate;
performing dicing process on the package substrate to which the silicon capacitor is soldered, to obtain the chip.

In the manufacturing method provided in the fifth aspect of this application, the silicon capacitor provided in the first aspect of this application could be adopted to improve decoupling effect and signal performance without increasing an overall size of the chip.

### BRIEF DESCRIPTION OF THE DRAWINGS

To illustrate the technical solutions in the embodiments of this application more clearly, the drawings used for describing the embodiments of this application will be illustrated below.
FIG. 1 is a schematic structural diagram of a silicon capacitor according to an embodiment of this application.
FIG. 2 is a schematic structural diagram of a package substrate according to an embodiment of this application.
FIG. 3 is a schematic structural diagram of the silicon capacitor as shown in FIG. 1 assembled with the package substrate as shown in FIG. 2.
FIG. 4 shows an evolution process of solder joints of a silicon capacitor according to an embodiment of this application.
FIG. 5 shows an evolution process of solder joints of a silicon capacitor according to another embodiment of this application.
FIG. 6 is a schematic structural diagram of a silicon capacitor according to another embodiment of this application.
FIG. 7 is a process flowchart of a manufacturing method for a silicon capacitor according to an embodiment of this application.
FIG. 8 is a top view of a chip according to an embodiment of this application.
FIG. 9 is a schematic structural diagram of a chip according to another embodiment of this application.
FIG. 10 is a top view of a chip according to another embodiment of this application.
FIG. 11 is a top view of a chip according to yet another embodiment of this application.
FIG. 12 is a process flowchart of a manufacturing method for a chip according to one embodiment of this application.

### Reference Numerals:

chip - 1, silicon capacitor - 10, silicon body - 11, silicon body layer - 111, redistribution layer - 112, connection portion - 1120, solder joint - 12, base - 121, soldering portion - 122, package substrate - 20, substrate - 21, solder pad - 22, solder ball - 23.

### DETAILED DESCRIPTION

The following describes preferred embodiments of this application. It should be understood that those with ordinary skills in the art may make various improvements and modifications without departing from the principles of this application, and such improvements and modifications are also deemed to fall within the scope of this application.

Before illustrating the technical solutions of this application, technical problems in relevant art are introduced in details.

In traditional schemes for De-coupling Capacity (Decap) of a packaged die, capacitors are surface-mounted on a top side of the packaged die or standard capacitors are surface-mounted on a bottom side of the packaged die, so as to reduce IR drop across the capacitors and ensure power delivery. A capacitor usually includes a body and two solder joints disposed on the body. Traditional capacitors, e.g., industry-standard capacitors in 0201/0402 packages or other form factors, have a center-to-center pitch between the two solder joints of 0.45mm or 0.775mm, respectively. A pitch between two solder pads in a package substrate is usually 0.35mm, or 0.4mm, etc. Thus, the center-to-center pitch between two solder joints are not consistent with the pitch between two solder pads.

As the pin density on a package substrate continues to increase, redistribution and interconnection between the package substrate and solder pads is required in the traditional method of surface-mounting a standard capacitor. This increases solder pads and routing for capacitors, which occupy layout area. For example, surface-mounting a capacitor on a top side of the package substrate will occupy a significant amount of layout area, which enlarges a package size of a chip, increases signal routing lengths, degrades signal performance, and fails to meet market and cost requirements. Yet, surface-mounting a capacitor on a bottom side of the package substrate will occupy a significant amount of layout area on the bottom side, which enlarges the package size of the chip, and a certain number of solder balls need to be removed according to a size of the capacitor. For example, with a pitch of solder pads designed to be 0.35mm, in order to surface-mount a traditional 0402 capacitor on the bottom side, 15 solder balls need to be removed, which reduces the number of solder balls, thereby reducing effective signal transmission, degrading electrical performance and signal performance, and failing to meet market and cost requirements.

For a chip in the art as above, due to the fact that a center-to-center pitch between two solder joints of a capacitor and that between two solder pads on a package substrate, a size of the chip is increased and electrical performance, such as signal performance and decoupling effect, is significantly degraded.

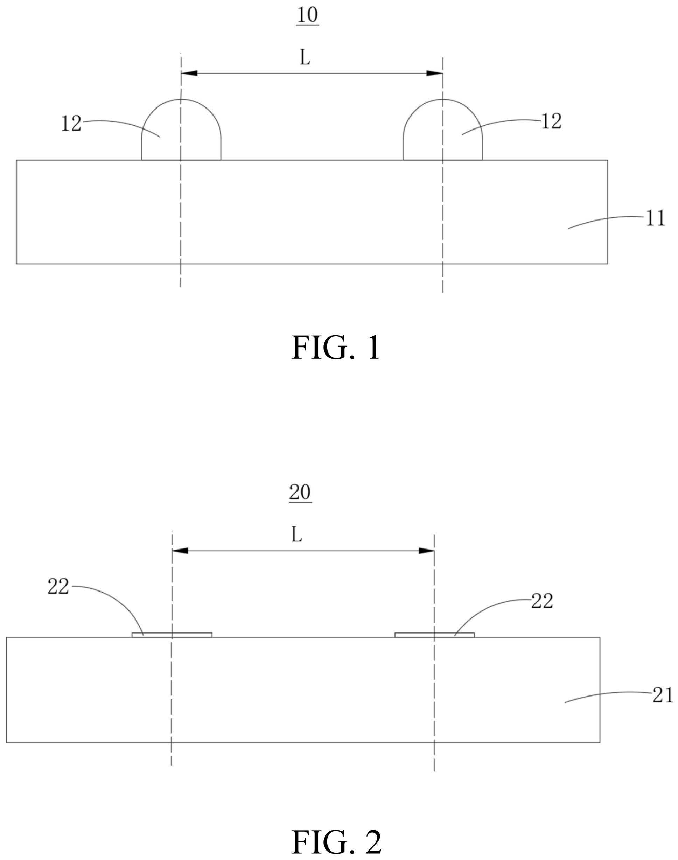

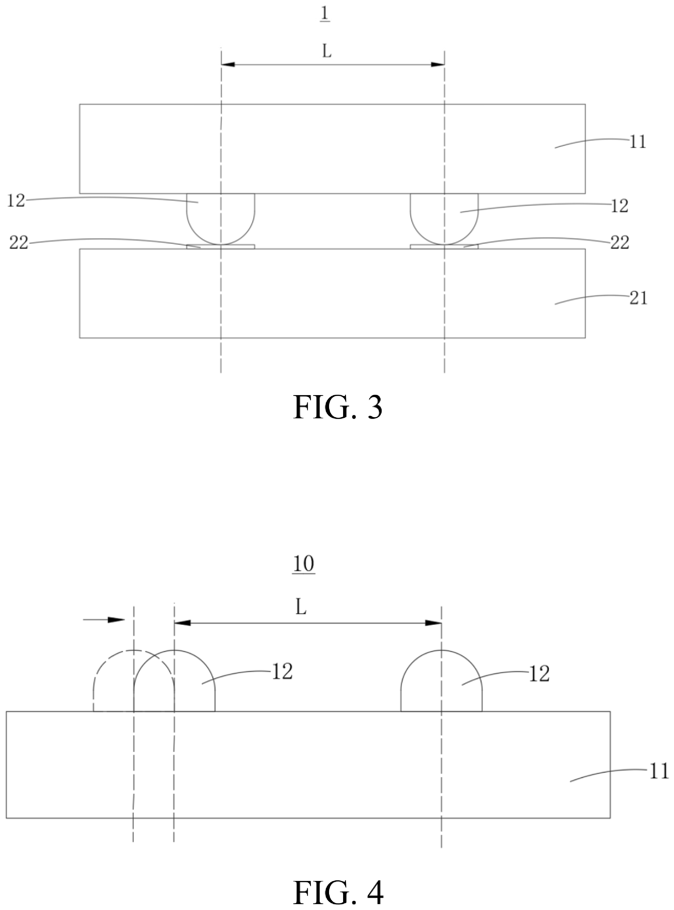

In view of this, in order to solve the above problems, this application provides a silicon capacitor. Referring to FIGS. 1-3 together, FIG. 1 is a schematic structural diagram of a silicon capacitor according to an embodiment of this application; FIG. 2 is a schematic structural diagram of a package substrate according to an embodiment of this application; FIG. 3 is a schematic structural diagram of the silicon capacitor as shown in FIG. 1 assembled with the package substrate as shown in FIG. 2. A silicon capacitor 10 provided in this embodiment comprises a silicon body 11, and two solder joints 12 disposed on one side of the silicon body 11 and spaced apart. A center-to-center pitch between the two solder joints 12 is a preset distance (shown as L in FIG. 1), which is equal to a center-to-center pitch between two adjacent solder pads 22 on a package substrate 20.

The silicon capacitor 10 provided in this embodiment may be applied in the field of chip 1 due to its characteristics such as small size, high stability, excellent highfrequency and temperature characteristics, extremely low bias, high reliability, and low-profile, etc. Specifically, the silicon capacitor 10 may be soldered to the package substrate 20 to obtain the corresponding chip 1.

The silicon capacitor 10 comprises a silicon body 11 and two solder joints 12. The silicon body 11 is the main structure of the silicon capacitor 10. It should be noted that, the silicon body 11 is not a single layer structure, but includes a structure with multiple different layers, such as a silicon body layer, a redistribution layer, and so on. The solder joints 12 are mainly used to solder the silicon body 11 to other components, thereby achieving electrical connection between the silicon body 11 and the other components. For example, the silicon capacitor 10 may be electrically connected to the package substrate 20 by soldering the solder joints 12 to the package substrate 20. It should be noted that, the solder joint 12 is not a single point, but a pillar structure with certain dimensions. The material of the solder joints 12 includes but is not limited to copper, tin, and so on.

From the above content, it can be seen that in the related art, the center-to-center pitch between two solder joints 12 is not equal to the center-to-center pitch between two solder pads 22. Wherein, the center-to-center pitch between two solder joints 12 can also be referred to as the solder joint pitch (pad pitch), and the center-to-center pitch between two solder pads 22 can also be referred to as pad pitch or ball grid array pitch (BGA pitch). The center-to-center pitch between two solder joints 12 is referred to as solder joint pitch hereinafter, and the center-to-center pitch between two solder pads 22 is referred to as the pad pitch hereinafter. The solder joint pitch is redesigned in this embodiment, specifically to be a preset distance, wherein the preset distance is equal to the pad pitch. That is, the solder joint pitch is equal to the pad pitch. This may not only facilitate soldering of the silicon capacitor 10 to the package substrate 20, but also does not affect routing design in the package substrate 20, ensuring the shortest path of power supply, without increasing the package area. Further, this prevents increasing the routing length of the package substrate 20 and thus increasing an overall size of the chip 1 due to the fact that the pad pitch on the package substrate 20 is unequal to the solder joint pitch. Also, decoupling effect and signal performance are improved.

Specifically, in this embodiment, the preset distance is 0.35mm or 0.4mm. Accordingly, the solder joint pitch is 0.35mm or 0.4mm.In other words, in this embodiment, the standard design of the package substrate 20 may keep unchanged, and the solder joint pitch may be changed to match the pad pitch on the package substrate 20. This embodiment is illustrated only with a solder joint pitch of 0.35mm, while in other embodiments, the solder joint pitch may be 0.4mm.

It should be noted that, this application involves physical characteristics of the silicon capacitor 10 itself. Users may directly solder the silicon capacitor 10 to the package substrate 20 without any operation in use of the silicon capacitor 10. The technical effect brought by this application will be automatically realized. In addition, users may visually observe the technical features of this application.

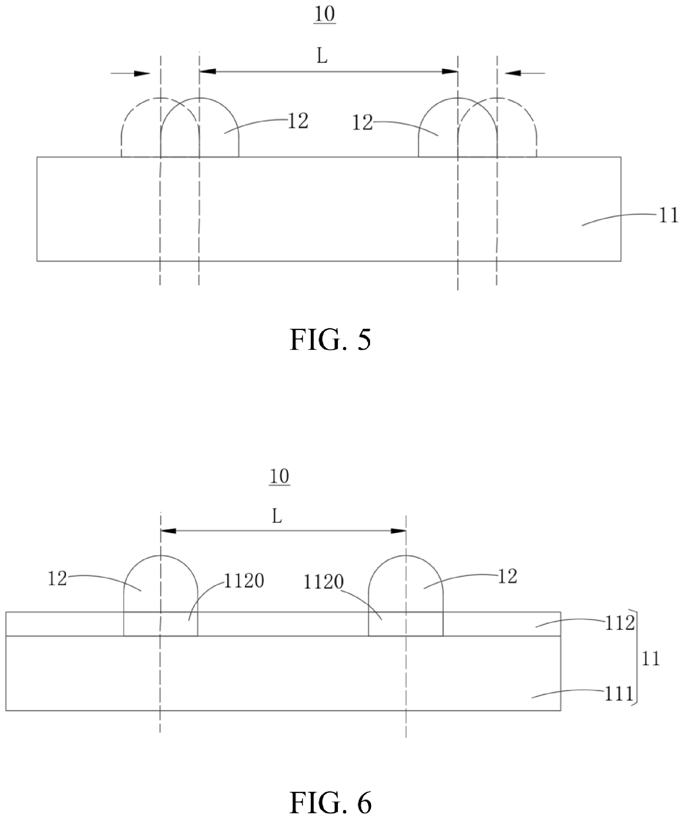

Referring to FIGS. 4-5 together, FIG. 4 shows an evolution process of solder joints of a silicon capacitor according to an embodiment of this application; FIG. 5 shows an evolution process of solder joints of a silicon capacitor according to another embodiment of this application. In this embodiment, any one of the two solder joints 12 is set to be closer to another of the two solder joints 12 so that the center-to-center pitch between the two solder joints 12 is the preset distance; or, each of the two solder joints 12 is set to be closer to another of the two solder joints 12 so that the center-to-center pitch between the two solder joints 12 is the preset distance.

From the above content, it can be seen that the center-to-center pitch between two solder joints 12 may be adjusted to match the center-to-center pitch between two solder pads 22 on the package substrate 20 in this embodiment. Specifically, as shown in FIG. 4, in one embodiment, one of the two solder joints 12 may be kept fixed, i.e., at the position as in the relevant art, and then the other solder joint 12 may be brought closer to the fixed solder joint 12, such that the center-to-center pitch between the two solder joints 12, i.e., the solder joint pitch, is changed. This could reduce design difficulty and decrease complexity of structural changes in some layers of the silicon body 11. As shown in FIG. 5, in another embodiment, the two solder joints 12 may be moved in a direction towards each other, such that the center-to-center pitch between the two solder joints 12, i.e., the solder joint pitch, is changed. This can make the overall structure of the silicon capacitor 10 more symmetrical, facilitating the subsequent soldering of the silicon capacitor 10 to the package substrate 20.

In addition, it should be noted that, when there are multiple silicon capacitors 10, two solder joints 12 of each of the silicon capacitors 10 could be brought closer to each other, or any one solder joint 12 of each of the silicon capacitors 10 may be kept fixed and the other solder joint 12 of each of the silicon capacitors 10 may be brought closer to the fixed solder joint 12, or two solder joints 12 of some silicon capacitors 10 could be brought more closer to each other, and one solder joint 12 of the remaining silicon capacitors 10 may be kept fixed and the other solder joint 12 of the remaining silicon capacitors 10 may be brought closer to the fixed solder joint 12.

Referring to FIG. 6, FIG. 6 is a schematic structural diagram of a silicon capacitor according to another embodiment of this application. In this embodiment, the silicon body 11 comprises a silicon body layer 111, and a redistribution layer 112 formed on one side of the silicon body layer, wherein two connection portions 1120 are disposed on one side of the redistribution layer 112 opposite the silicon body layer 111, and each of the solder joints 12 is disposed on one of the connection portions 1120, and the center-to-center pitch between the two connection portions 1120 is the preset distance.

The silicon body 11 comprises but is not limited to the silicon body layer 111 and the redistribution layer 112, wherein the silicon body layer 111 may also include a structure of multiple layers. Therefore, the silicon body layer 111 in this embodiment is only a general term and does not mean that there is only one layer in the silicon body layer 111. A redistribution/re-distributed layer 112 (RDL) designed with multiple routing traces is formed on one side of the silicon body layer 111. Two connection portions 1120 are disposed on one side of the redistribution layer 112 opposite the silicon body layer 111. Solder joints 12 are disposed on the connection portions 1120. In other words, one solder joint 12 is disposed on one connection portion 1120, and the other solder joint 12 is disposed on another connection portion 1120. The solder joints 12 are electrically connected to the connection portion 1120 and components inside the silicon body layer 111 through routing.

Therefore, the center-to-center pitch between the two solder joints 12 may depend on the center-to-center pitch between the two connection portions 1120. In this embodiment, the center-to-center pitch between the two connection portions 1120 is a preset distance, so that positions of the solder pads 22 on a surface of the silicon capacitor 10 is designed according to the set pitch. Therefore, after the solder joints 12 are disposed on the connection portions 1120, it is easier to enable the center-to-center pitch between the two solder joints 12 to be the preset distance, which reduces design difficulty of the silicon capacitor 10.

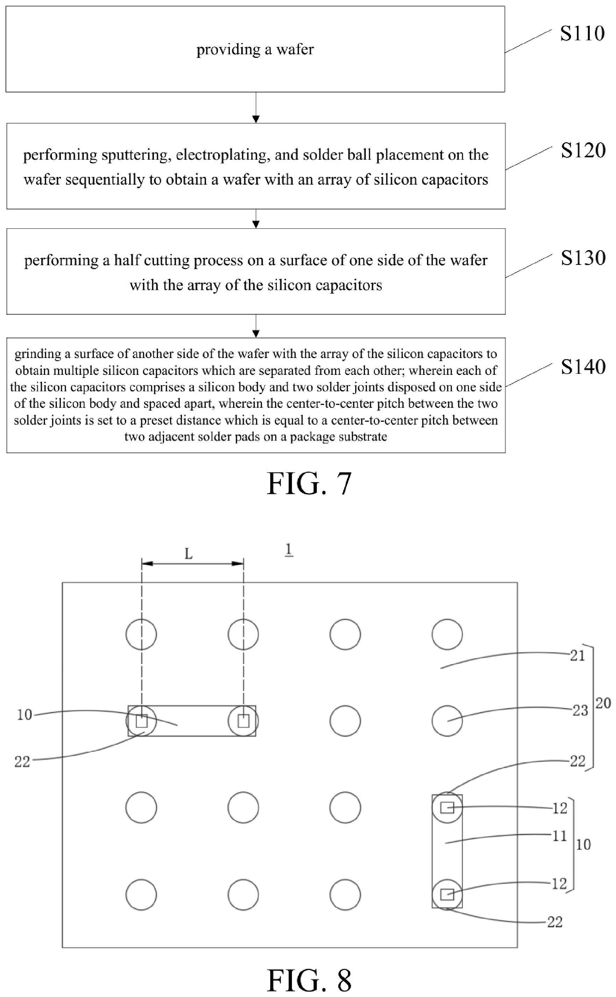

Referring to FIG. 7, FIG. 7 is a process flowchart of a manufacturing method for a silicon capacitor according to one embodiment of this application. This embodiment provides a manufacturing method for a silicon capacitor 10, which comprises steps S110, S120, S130, and S140. Wherein, S110, S120, S130, and S140 are introduced in details as follows.

At S110, a wafer is provided.

At S120, sputtering, electroplating, and solder ball placement are performed on the wafer sequentially to obtain a wafer with an array of silicon capacitors.

At S130, a half cutting process is performed on a surface of one side of the wafer with the array of the silicon capacitors.

At S140, a surface of another side of the wafer with the array of the silicon capacitors is grinded to obtain multiple silicon capacitors 10 which are separated from each other; wherein each of the silicon capacitors 10 comprises a silicon body 11 and two solder joints 12 disposed on one side of the silicon body 11 and spaced apart, wherein the center-to-center pitch between the two solder joints 12 is a preset distance which is equal to a center-to-center pitch between two adjacent solder pads 22 on a package substrate 20.

In this embodiment, a wafer may be provided firstly, and then wafer incoming inspection, plasma cleaning, sputtering, photolithography (PR photo), electroplating, solder ball placement, photoresist stripping (PR strip), etching, reflow, plasma cleaning are performed sequentially, thus bumping process is completed and a wafer with an array of silicon capacitors 10 is obtained, wherein the array of silicon capacitors 10 comprises multiple silicon capacitors 10 connected with each other. Subsequently, bottom-side grinding process is performed, which can also be referred to as Dicing Before Grinding (DBG) process. Specifically, for the wafer with the array of silicon capacitors 10, wafer incoming inspection, cutting to half the depth of dicing streets between units of the silicon capacitors 10 (also known as half cutting), and surface taping on the cutting side are performed in sequentially. The taped wafer is flipped and inline grinding process is performed on a surface of the other side of the wafer with the array of silicon capacitors 10, such that the wafer is gradually thinned until the streets are exposed. At this time, the multiple silicon capacitors 10 which are originally connected to each other are separated from each other, resulting in the silicon capacitor 10 provided in the above embodiments of this application. Specifically, each silicon capacitor 10 comprises a silicon body 11, and two solder joints 12 disposed on one side of the silicon body 11 and spaced apart, wherein a center-to-center pitch between the two solder joints 12 is a preset distance which is equal to a center-to-center pitch between two adjacent solder pads 22 on a package substrate 20. Then, automatic optical inspection (AOI), ultraviolet irradiation (UV), tape&reel packaging, final visual inspection (FVI), and packaging are performed, and then the silicon capacitors 10 may be delivered to various users as needed.

As the above, this embodiment provides a wafer dicing process for silicon capacitors 10, which solves problems of dicing outlines of ultra-thin silicon capacitors 10 by cutting to half the depth of the dicing streets between the silicon capacitors 10 of the chips 1 firstly, and then separating the individual silicon capacitors 10 through grinding, thereby reducing the difficulty of manufacturing silicon capacitors 10. The silicon capacitor 10 provided in the above embodiments of this application may be manufactured through the above manufacturing process, which enables the center-to-center pitch between two solder joints 12 to be equal to the center-to-center pitch between two solder pads 22 when the silicon capacitor 10 is soldered to the package substrate 20. This may not only facilitate soldering of the silicon capacitor 10 to the package substrate 20, but also does not affect the routing design in the package substrate 20, thereby ensuring the shortest path of power supply, without increasing the package area. Further, this prevents increasing the routing length of the package substrate 20 and thus increasing an overall size of the chip 1 due to the fact that the center-to-center pitch between the two solder pads 22 on the package substrate 20 are unequal to the center-to-center pitch between the two solder joints 12 of the silicon capacitor 10. Also, decoupling effect and signal performance are improved.

Referring to FIGS. 1-3 and FIG. 8 together, FIG. 8 is a top view of a chip according to an embodiment of this application. This embodiment provides a chip 1. The chip 1 comprises a package substrate 20 and a silicon capacitor 10 provided in above embodiments of this application, wherein the package substrate 20 comprises a substrate 21, multiple solder pads 22 disposed on one side of the substrate 21 and spaced apart, and multiple solder balls 23 disposed on the one side of the substrate 21 and spaced apart, wherein a center-to-center pitch between two adjacent solder pads 22 is equal to a center-to-center pitch between two adjacent solder balls 23, and equal to a preset distance between two solder joints 12 of the silicon capacitor 10, and wherein the solder joints 12 are soldered to the solder pads 22.

The chip 1 provided in this embodiment is composed of a silicon capacitor 10 soldered to a package substrate 20. The package substrate 20 comprises a substrate 21, multiple solder pads 22 disposed on one side of the substrate 21 and spaced apart, and multiple solder balls 23 disposed on the one side of the substrate 21 and spaced apart. The above content can be understood in a way that multiple solder balls 23 were originally intended to be uniformly disposed in an array on one side of the substrate 21; however, since a capacitor needs to be soldered, positions originally intended for the solder balls 23 may be left vacant, exposing the solder pad 22 on the surface of the substrate 21, thereby facilitating soldering of the silicon capacitor 10 to the solder pad 22 subsequently. Therefore, the center-to-center pitch between adjacent solder pads 22 is equal to the center-to-center pitch between adjacent solder balls 23, wherein positions of solder pads 22 should originally be positions of solder balls 23. So the center-to-center pitch between two solder joints 12 of the silicon capacitor 10, which is the preset distance, is equal to the center-to-center pitch between two solder pads 22 and equal to the center-to-center pitch between two solder balls 23. Optionally, the solder pads 22 and solder balls 23 are disposed on the bottom of the substrate 21, so that the silicon capacitor 10 is surface-mounted on the bottom-side of the package substrate 20.

In the embodiments, with the silicon capacitor 10 provided in the above embodiments, the center-to-center pitch between the two solder joints 12 may be equal to the center-to-center pitch between the two solder pads 22 when the silicon capacitor 10 is soldered to the package substrate 20. This may not only facilitate soldering of the silicon capacitor 10 to the package substrate 20, but also does not affect the routing design in the package substrate 20, thereby ensuring the shortest path of power supply, without increasing the package area. Further, this prevents increasing the routing length of the package substrate 20 and thus increasing an overall size of the chip 1 due to the fact that the center-to-center pitch between the two solder pads 22 on the package substrate 20 is unequal to the center-to-center pitch between the two solder joints 12 of the silicon capacitor 10. Also, decoupling effect and signal performance are improved.

It should be noted that the silicon capacitor 10 provided in this embodiment may be applied to chips 1 of all kinds of Flip-Chip Chip Scale Package (FCCSP) with the pad pitch of 0.35mm or 0.4mm.

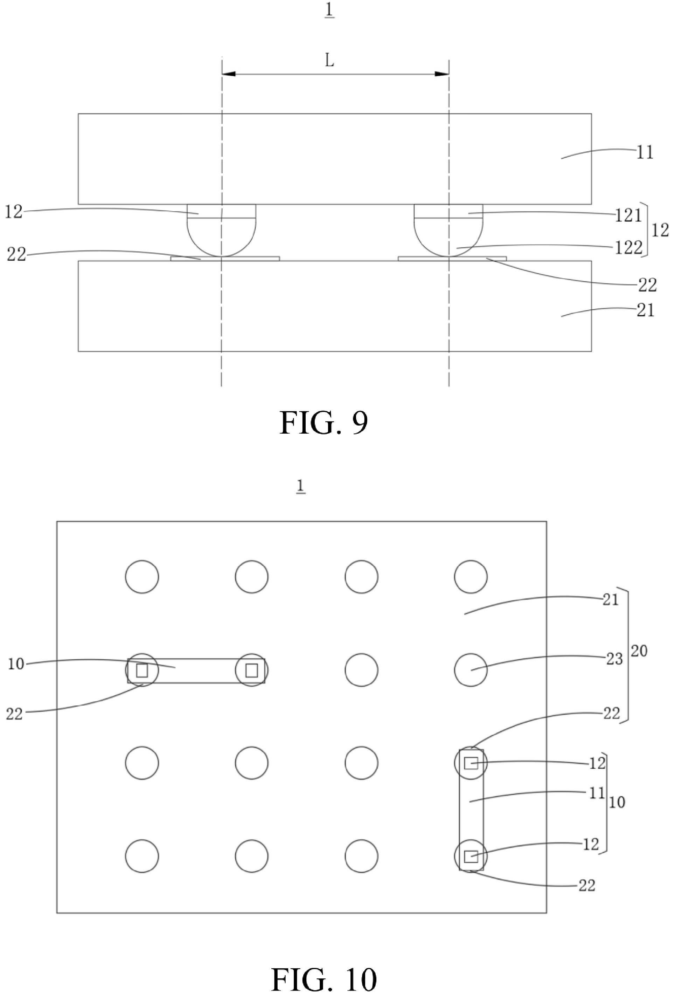

Referring to FIG. 9, FIG. 9 is a schematic structural diagram of a chip according to another embodiment of this application. In this embodiment, the solder joint 12 includes a base 121 disposed on a silicon body 11 of the silicon capacitor 10, and a soldering portion 122 disposed on a side of the base 121 opposite the silicon body 11, wherein an orthographic projection of the soldering portion 122 onto the substrate 21 is located within the solder pad 22.

The solder joint 12 includes a base 121 disposed on the silicon body 11, and a soldering portion 122 disposed on the base 121, wherein the base 121 is used to be connected with the silicon body 11, and the soldering portion 122 is used to be soldered to the solder pad 22 on the package substrate 20. In this embodiment, based on that the solder joint pitch is equal to the pad pitch, the orthographic projection of the soldering portion 122 onto the substrate 21 is located within the solder pad 22. In other words, the soldering portion 122 directly faces the solder pad 22 and an area of the soldering portion 122 is smaller than that of the solder pad 22, facilitating soldering of the solder joint 12 to the solder pad 22.

Furthermore, referring to FIG. 9 again, in this embodiment, a center of the orthographic projection of the soldering portion 122 onto the substrate 21 may be overlapped with a center of the solder pad 22. That is, the center of the soldering portion 122 overlaps with the center of the solder pad 22, thereby facilitating soldering of the solder joint 12 to the solder pad 22.

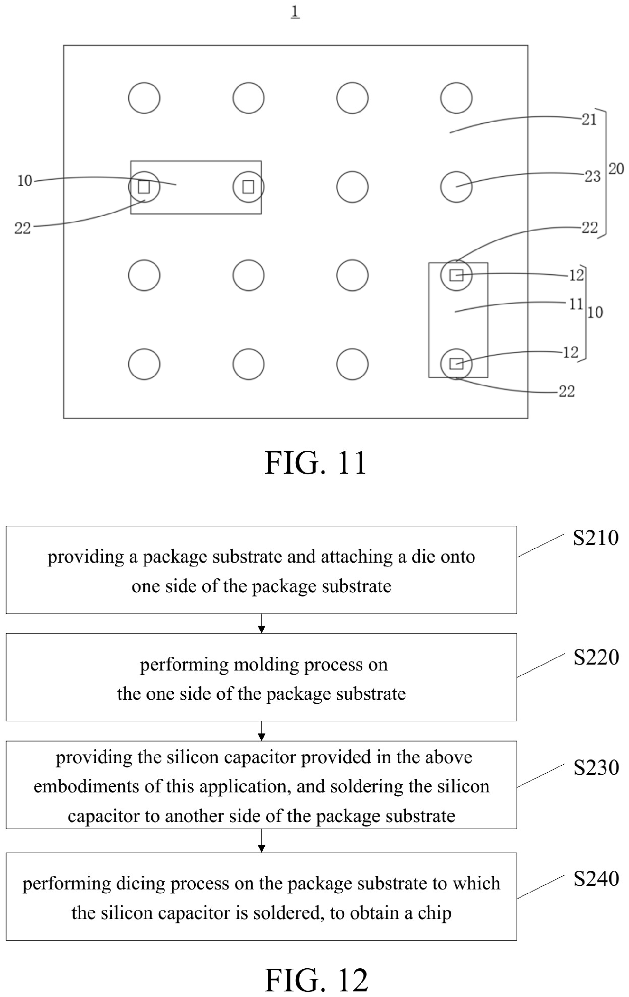

Referring to FIGS. 8, 10-11 together, FIG. 10 is a top view of a chip according to another embodiment of this application; FIG. 11 is a top view of a chip according to yet another embodiment of this application. In this embodiment, in a direction perpendicular to an arrangement direction of the two solder joints 12, a width of the silicon body 11 is smaller than a width of the solder pad 22; or the width of the silicon body 11 is greater than or equal to the width of the solder pad 22.

From the above content, it can be seen that the solder joint 12 is disposed on the silicon body 11 and the size of solder joint 12 is smaller than that of silicon body 11, and thus overall length and width dimensions of the silicon capacitor 10 are same as that of the silicon body 11. In this embodiment, the arrangement direction of the two solder joints 12 may be deemed as the length direction of the silicon capacitor 10, and a direction perpendicular to the arrangement direction of the two solder joints 12 may be deemed as the width direction of the silicon capacitor 10. As shown in FIG. 10, in one embodiment, the width of the silicon body 11 may be smaller than that of the solder pad 22. This can reduce the overall size of the silicon capacitor 10, thus reducing the capacitance of the silicon capacitor 10. As shown in FIGS. 8 and 11, in another embodiment, the width of the silicon body 11 may be not smaller than that of the solder pad 22. This can increase the overall size of the silicon capacitor 10, thus increasing the capacitance of the silicon capacitor 10.

From the above, in this embodiment, users may make appropriate adjustments based on their capacitance requirements, so as to meet different requirements for electrical performance.

Referring to FIG. 12, FIG. 12 is a process flowchart of a manufacturing method for a chip according to one embodiment of this application. This embodiment provides a manufacturing method for a chip 1, which comprises steps S210, S220, S230, and S240. Wherein, S210, S220, S230, and S240 are introduced in details as follows.

At S210, a package substrate 20 is provided and a die is attached onto one side of the package substrate 20.

At S220, molding process is performed on the one side of the package substrate 20.

At S230, the silicon capacitor 10 provided in the above embodiments of this application is provided, and the silicon capacitor 10 is soldered to another side of the package substrate 20.

At S240, dicing process is performed on the package substrate 20 to which the silicon capacitor 10 is soldered, to obtain the chip 1.

In this embodiment, the silicon capacitor 10 may be mounted onto a bottom side of the package substrate 20 using Surface Mount Technology (SMT). Specifically, a die may be attached to the package substrate 20 using Flip Chip (FC) and Wire Bonding (WB) firstly. Then, molding process is performed on the top side of the package substrate 20 for packaging. Subsequently, the silicon capacitor 10 is mounted to the other side of the package substrate 20 using the SMT process. For example, the silicon capacitor 10 with a pitch of 0.35mm between solder joints is directly soldered to the package substrate 20 with a pitch of 0.35mm between solder pads. Finally, chip 1 is obtained through singulation.

In the manufacturing method provided in this embodiment, with the silicon capacitor 10 provided in the above embodiments of this application, the center-to-center pitch between the two solder joints 12 is equal to the center-to-center pitch between the two solder pads 22 when the silicon capacitor 10 is soldered to the package substrate 20. This may not only facilitate soldering of the silicon capacitor 10 to the package substrate 20, but also does not affect the routing design in the package substrate 20, thereby ensuring the shortest path of power supply, without increasing the package area. Further, this prevents increasing the routing length of the package substrate 20 and thus increasing an overall size of the chip 1 due to the fact that the center-to-center pitch between the two solder pads 22 on the package substrate 20 is unequal to the center-to-center pitch between the two solder joints 12 of the silicon capacitor 10. Also, decoupling effect and signal performance are improved.

In the description of this application, it should be understood that, solely for ease of description and simplification of this application, the orientation or positional relationship indicated by the terms "center", "longitudinal", "lateral", "length", "width", "thickness", "up", "down", "front", "back", "left", "right", "vertical", "horizontal", "top", "bottom", "inside", "outside", "clockwise", "counter-clockwise", etc., is based on the orientation or positional relationship shown in the accompanying drawings, and does not indicate or imply that the described device or element must be in a specific orientation or be constructed or operated in a specific orientation, which should not be construed as limiting this application.

In addition, the terms "first" and "second" are solely used for descriptive purposes and should not be understood as indicating or implying relative importance or implying the number of the referred technical features. Thus, the features defined with the terms "first" and "second" may explicitly or implicitly include one or more of these features. In the description of this application, the terms "multiple" refers to two or more, unless otherwise specifically defined. In addition, the terms "include" and "have" as well as any variations thereof are intended to cover non exclusive inclusions.

In this application, unless otherwise specified and defined, the terms "installation", "connection", "connecting", "fix", etc. should be broadly interpreted. For example, they could be connection, detachable connection, or integration, could be mechanical connection or electrical connection, could be directly connection or indirectly connection through an intermediate medium, or could be connectivity within two components or an interaction relationship between two components. For those with ordinary skills in the art, the specific meanings of the above terms in this application could be interpreted according to the specific situation.

The foregoing has illustrated the embodiments of this application in details, and explained the principles and implementation manners thereof. Such description is provided solely to facilitate understanding of the methods and their core concepts of this application. However, the content of the Description should not be construed as limiting this application. Those skilled in the art shall make various modifications and variations to this application without departing from the spirit and scope of this application. These modifications and variations to this application fall within the scope of the appended claims and their equivalent technologies.

## Claims

1. A silicon capacitor, **characterized in that**, the silicon capacitor comprises: a silicon body, and two solder joints disposed on one side of the silicon body and spaced apart, wherein a center-to-center pitch between the two solder joints is a preset distance which is equal to a center-to-center pitch between two adjacent solder pads on a package substrate.

2. The silicon capacitor according to claim 1, **characterized in that**, the preset distance is 0.35mm or 0.4mm.

3. The silicon capacitor according to claim 1, **characterized in that**, any one of the two solder joints is set to be closer to another of the two solder joints so that the center-to-center pitch between the two solder joints is the preset distance; or, each of the two solder joints is set to be closer to another of the two solder joints so that the center-to-center pitch between the two solder joints is the preset distance.

4. The silicon capacitor according to claim 3, **characterized in that**, the silicon body comprises a silicon body layer and a redistribution layer formed on one side of the silicon body layer, wherein two connection portions are disposed on one side of the redistribution layer opposite the silicon body layer, and each of the solder joints is disposed on one of the connection portions, and a center-to-center pitch between the two connection portions is the preset distance.

5. A manufacturing method for a silicon capacitor, **characterized in that**, the manufacturing method comprises:
providing a wafer;
performing sputtering, electroplating, and solder ball placement on the wafer sequentially to obtain a wafer with an array of silicon capacitors;
performing a half cutting process on a surface of one side of the wafer with the array of the silicon capacitors;
grinding a surface of another side of the wafer with the array of the silicon capacitors to obtain multiple silicon capacitors which are separated from each other; wherein each of the silicon capacitors comprises a silicon body and two solder joints disposed on one side of the silicon body and spaced apart, wherein a center-to-center pitch between the two solder joints is a preset distance which is equal to a center-to-center pitch between two adjacent solder pads on a package substrate.

6. A chip, **characterized in that**, the chip comprises a package substrate and the silicon capacitor according to any one of claims **1-4,** wherein the package substrate comprises a substrate, multiple solder pads disposed on one side of the substrate and spaced apart, and multiple solder balls disposed on the one side of the substrate and spaced apart, wherein a center-to-center pitch between two adjacent solder pads of the solder pads is equal to a center-to-center pitch between two adjacent solder balls of the solder balls, and equal to a preset distance between two solder joints of the silicon capacitor, and wherein the solder joints are soldered to the solder pads.

7. The chip according to claim 6, **characterized in that**, the solder joints include a base disposed on a silicon body of the silicon capacitor, and a soldering portion disposed on a side of the base opposite the silicon body, wherein an orthographic projection of the soldering portion onto the substrate is located within a solder pad of the solder pads.

8. The chip according to claim 7, **characterized in that**, a center of the orthographic projection of the soldering portion onto the substrate overlaps with a center of the solder pad.

9. The chip according to claim 6, **characterized in that**, in a direction perpendicular to an arrangement direction of the two solder joints, a width of the silicon body is smaller than a width of the solder pad; or the width of the silicon body is greater than or equal to the width of the solder pad.

10. A manufacturing method for a chip, **characterized in that**, the manufacturing method comprises:
providing a package substrate and attaching a die onto one side of the package substrate;
performing a molding process on the one side of the package substrate;
providing the silicon capacitor according to any one of claims **1-4,** and soldering the silicon capacitor to another side of the package substrate;
performing a dicing process on the package substrate to which the silicon capacitor is soldered, to obtain the chip.
